# EUROPÄISCHE PATENTSCHRIFT

(11) **EP 1 078 825 B1**
(45) Veröffentlichungstag und Bekanntmachung des Hinweises auf die Patenterteilung: **01.08.2007**
(21) Anmeldenummer: 00117419.2
(22) Anmeldetag: 11.08.2000
(51) Int. Cl.: B60R 21/26

(54) **Pyrotechnisches Zündsystem mit integrierter Zündschaltung**
Pyrotechnic ignition device with integrated ignition circuit
Système d'allumage pyrotechnique avec circuit de déclenchement intégré

(30) Priorität: 25.08.1999 DE 19940200; 25.08.1999 DE 19940201
(43) Veröffentlichungstag der Anmeldung: 28.02.2001
(73) Patentinhaber: Conti Temic microelectronic GmbH, 90411 Nürnberg (DE); TRW Airbag Systems GmbH, 84544 Aschau am Inn (DE)
(72) Erfinder: Baur, Richard, 85276 Pfaffenhofen (DE); Fendt, Günter, Dipl.-Ing. (FH), 86529 Schrobenhausen (DE); Küblbeck, Hermann, Dipl.-Phys., 86529 Schrobenhausen (DE); Laucht, Horst, Dr.-Ing., 83052 Bruckmühl (DE); Wöhrl, Alfons, Dipl.-Ing. (FH), 86529 Schrobenhausen (DE)

(56) Entgegenhaltungen:
- EP-A- 0 555 651
- DE-C- 19 610 799
- US-A- 4 819 560
- US-A- 5 889 228

## Beschreibung

Die Erfindung betrifft ein pyrotechnisches Zündsystem mit integrierter Zündschaltung gemäß dem Oberbegriff des Anspruchs 1.
Pyrotechnische Zündsysteme dienen insbesondere zur Auslösung von Insassenrückhalteeinrichtungen, können aber grundsätzlich auch auf militärischem Gebiet oder im Bergbau eingesetzt werden. Durch Freisetzung von Energie durch den Zünder wird eine pyrotechnische Treibladung angezündet. Die Energie wird dabei elektrisch in Form einer Zündspannung zugeführt, die durch elektrische Bauelemente erzeugt und/oder gespeichert wird.
Ein solches Zündsystem ist bspw. aus der DE 37 17 149 C3 bekannt und wird dort als Sprengzünder-Zündelement bezeichnet. Auch in diesem Fall werden elektrische Bauelemente, insbesondere ein elektronischer Schaltkreis eingesetzt, der eine Überspannungsschutzeinrichtung, eine Kommunikationseinrichtung, ein Zeitgeber- und Sperrschaltkreis sowie ein Selbsttestmodul enthält. Zur Energiespeicherung dient ein Zündkondensator, der aufgrund seiner großen Größe nicht in den Schaltkreis integriert ist, sondern als ein getrenntes Bauteil ausgeführt wird.
Bei Zündsystemen mit integrierten Zündschaltungen ohne Zündkondensator, wie sie beispielsweise dem Artikel von Willis, K: An introduction to semiconductor initiation of electroexplosive devices, in: 2. internat. symposium on sophisticated car occupant safety systems, airbag 2000, Karlsruhe 1994, S. 42-1 bis 42-9 vorgestellt sind, muß die Zündenergie zum Zeitpunkt der Auslösung der im Zündsystem integrierten Schaltung zugeführt werden, wodurch die verfügbare Zündenergie, die Auslösegeschwindigkeit und Auslösesicherheit herabgesetzt ist.
Die Patentanmeldungen DE 198 36 280 und DE 198 36 278 beschreiben ebenfalls eine ansteuerbare Anzündeinheit mit integrierter Elektronik zum Auslösen eines Rückhaltesystems sowie ein pyrotechnisches Anzündelement, wobei dort Gegenstand der Anmeldung die Abschirmung der Schaltung vor den Einflüssen der Explosion ist. Die Schaltung ist dabei jeweils auf einem Leiterplattenträgerelement angeordnet.

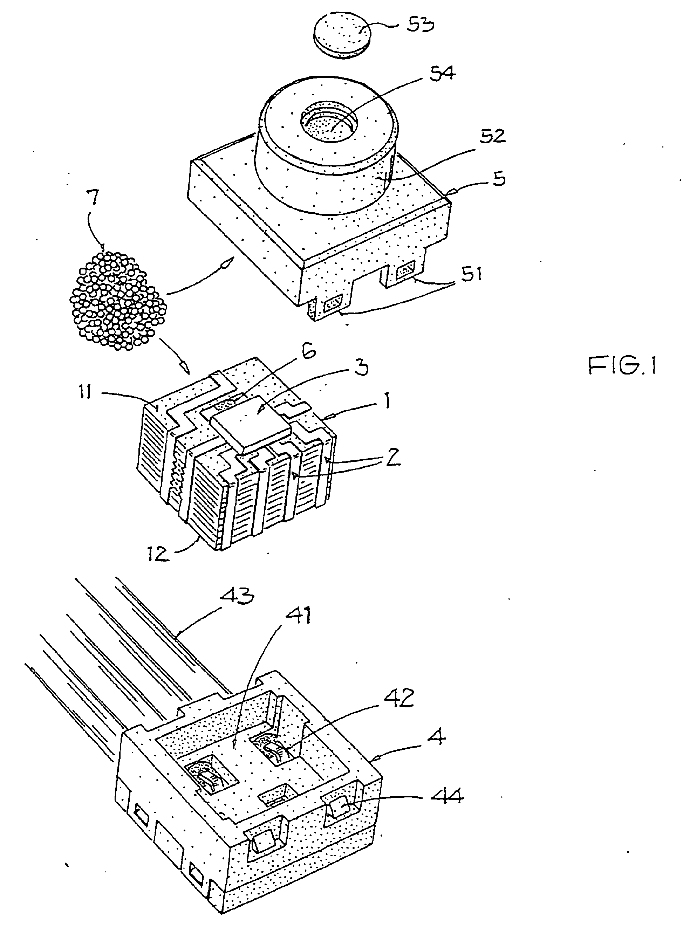

Die DE 3537820 A1 und die DE 196 53 115 A1 stellen jeweils eine Zündeinheit zum Zünden eines pyrotechnischen Treibsatzes vor, bei denen neben einem elektrisch zündbaren Zünder auch ein Zündenergiespeicher sowie eine Verriegelungseinheit gemeinsam auf einem Halbleiterchip integriert ist, wobei die Verriegelungseinheit aufgrund eines Entriegelungssignals die Entladung des Energiespeichers über den Elektrozünder bewirkt. Die Energiespeicherung mittels Halbleiterkondensatoren ist jedoch zumindest für eine Reihe von Zündern nicht ausreichend.
Die Integration elektrischer Bauelementen in ein pyrotechnisches Anzündelement ist auch Gegenstand der DE 196 10 799 C1, wobei dort aus einem Metallband eine Leiterbahnstruktur ausgestanzt und dreidimensional gebogen wird, diese Leiterbahnen mit einem quaderförmigen Trägerkörper umspritzt werden, wobei in Aussparungen im Trägerkörper nachfolgend Bauelemente eingesetzt werden können, die mit den Leiterbahnen verbunden werden. Der großräumige Zündenergiekondensator wird dabei in einem Hohlraum innerhalb des Trägerkörpers platzsparend verstaut. Ebenso ist eine integrierte Schaltung zur Auslösung vorgesehen. Danach wir die Baugruppe durch ein Gehäuse umschlossen. Der Aufwand für die Herstellung eines solchen Anzündelements und die Störanfälligkeit aufgrund der filigranen Bauweise ist enorm.
Die DE 198 46 110 A1 zeigt die Verwendung separater Substrate (7,8) als Trägerelemente für ein Zündsystem mit elektrischen Bauelementen (9), die auf den zwei parallel zueinander beabstandet angeordneten Substraten (7 und 8) beidseitig angeordnet sind (vgl. bspw. Fig. 1 und Sp. 2, Z. 45 ff.). Die auf den zwei zueinander gerichteten Seiten der Substrate 7 und 8 befindlichen Bauelemente (9) liegen zwecks platzsparender Bauweise äußerst nah aneinander. Eine direkte Verbindung dieser zueinander liegenden Bauelemente (9) der Substrate (7,8) ist jedoch nicht offenbart und würde üblicherweise zu einer elektrischen Fehlfunktion, bspw. einem Kurzschluss führen.
Die nachveröffentlichte DE 199 45 790 A1 zeigt in der dortigen Figur 4 ebenfalls ein Zündsystem, in dem beidseitig eines Trägers (Bezugszeichen 64a weist zwar auf diesen Träger, wird jedoch anderweitig verwandt) angeordnet einen elektronischen Schaltkreis (66) und einen Kondensator (67) auf.
Aufgabe der Erfindung ist es, ein weiteres pyrotechnisches Zündsystem mit integrierten Zündschaltung vorzustellen, welches sehr platzsparend und zudem einfach und kostengünstig herstellbar ist.

Diese Aufgabe wird durch die Merkmale des Patentanspruchs 1 gelöst. Vorteilhafte Weiterbildungen sind den Unteransprüche zu entnehmen.
Grundgedanke der Erfindung ist es, ein bereits vorgesehenes elektrisches Bauelement mit zumindest einer ebenen, zumindest bereichsweise selbst nichtleitfähigen Außenfläche als Trägerelement für die anderen Bauelemente und die Schaltung zu verwenden und diese dort anzuordnen. Durch diese Lösung entfällt ein sonst üblicherweise in Form einer Leiterplatte vorgesehenes oder in der DE 196 10 799 C1 quaderförmig ausgebildetes zusätzliches Trägerelement, wodurch neben der Materialeinsparung insbesondere auch der Platzbedarf reduziert, die Fertigung vereinfacht und so die Zuverlässigkeit erhöht wird.
Ausgehend davon ergeben sich eine Vielzahl von Weiterbildungen.
In ganz besonders vorteilhafter Weise eignet sich gerade eine Kondensatoranordnung, beispielsweise die Plattenkondensatoranordnung eines Zündkondensators aufgrund der recht erheblichen Größe und geraden Außenfläche als Trägerelement.
So wird betreffend der Anordnung und Ausgestaltung der Leiterbahnstruktur vorgeschlagen, in einfacher Weise durch metallische Einlegeteile im Gehäuse ausgebildet sein oder am Gehäuse oder auf selbst nicht leitenden Außenflächen der Kondensatoranordnung aufgedampft, abgeschieden oder aufgeklebt werden kann.
Die Einlegeteile ermöglichen im Zusammenspiel mit dem Gehäuse ebenfalls eine äußerst kompakte und einfache Bauform und können sowohl für die Verbindung zwischen Kondensatoranordnung und Schaltkreis als auch hin zu äußeren Anschlüssen verwendet werden, wobei die äußeren Anschlüsse in besonders bevorzugter Weiterbildung sogar direkt aus diesen Einlegeteilen ausgeformt sein können.
Eine Anordnung der Leiterbahnstruktur auf dem Trägerelement ermöglicht die Ausbildung von Kontaktzonen, die in Verbindung mit entsprechenden Kontaktzonen des Schaltkreises stehen. Besonders vorteilhaft ist es, Schaltkreise als Bauelemente in Form von unverpackten Halbleiterchips, sogenannten Nacktchips ohne Gehäuse oder in Flip-Chip-Technik mit ihrer strukturierten und mit Kontaktzonen versehenen Seite nach unten auf die Leitbahnstruktur zu montieren. Die Leiterbahnstruktur kann auch an den Seitenflächen der Kondensatoranordnung zur Zusammenschaltung der einzelnen Kondensatorbeläge genutzt werden oder eine Verbindung zu weiteren Kontaktzonen schaffen, mit denen das Zündsystem über im Inneren des Gehäuses zugeordnete Kontaktelemente mit einer Auslöseelektronik, bspw. einem Zentralgerät eines Insassenschutzsystems verbunden ist.
Die Erfindung wird nachfolgend anhand von Ausführungsbeispielen und Figuren näher erläutert.
Kurze Beschreibung der Figuren:
- Figur 1: Explosionsdarstellung von einer Baugruppe mit einer Kondensatoranordnung mit darauf abgeschiedenen Leitbahnen und Bauelementen sowie dem Gehäuse
- Figur 2: Oberseite der Kondensatoranordnung sowie die darauf angeordneten Leitbahnen, Schaltkreise und Zündschicht
- Figur 3: Unterseite der Kondensatoranordnung mit Kontaktzonen zum Gehäuseunterteil
- Figur 4: Schnitt durch eine Ausgestaltung mit Zündschicht auf der Oberfläche des Zündkondensators
- Figur 5: Schnitt durch eine Ausgestaltung mit Zündschicht auf der Oberfläche des integrierten Schaltkreises
- Figur 6: Pyrotechnisches Zündsystem mit einer Kondensatoranordnung in einem Gehäuse, auf dieser montiert ein Schaltkreis sowie mit einem Gehäuse mit eingespritzten Einlegeteilen skizzenhaft teilweise aufgeschnitten
- Figur 7: Explosionsdarstellung der Ausgestaltung gemäß der Figur 6
- Figur 8: Explosionsdarstellung einer weiteren Ausgestaltung ebenfalls mit einer durch Einlegeteile gebildeten Leiterbahnstruktur
- Figur 9: skizzenhafte Darstellung einer komplettierten Baugruppe mit Steckerkontaktbereich mit Visualisierung des darin angeordneten pyrotechnischen Zündsystems

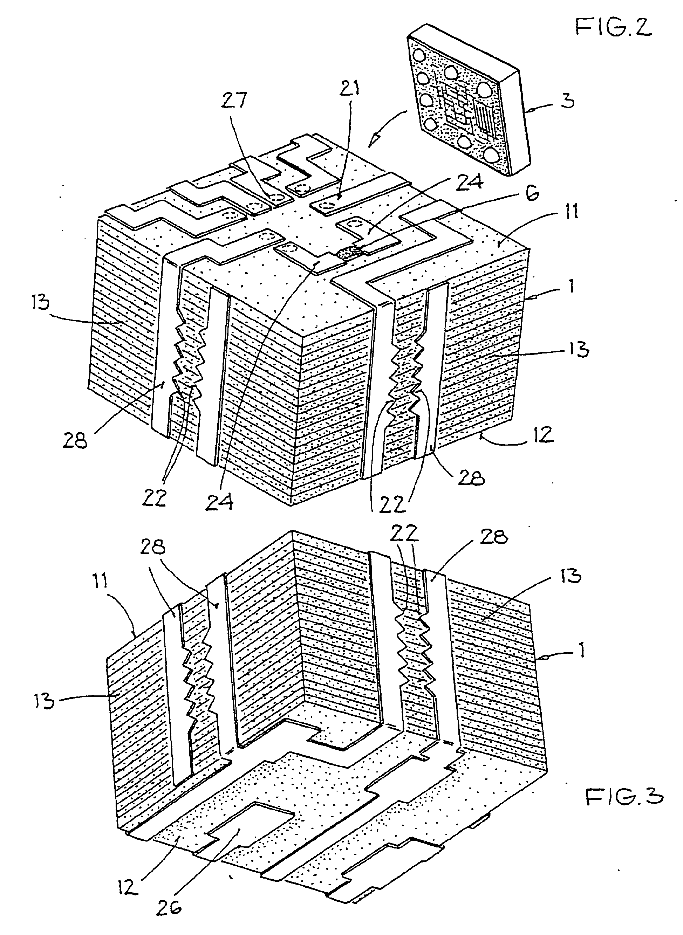

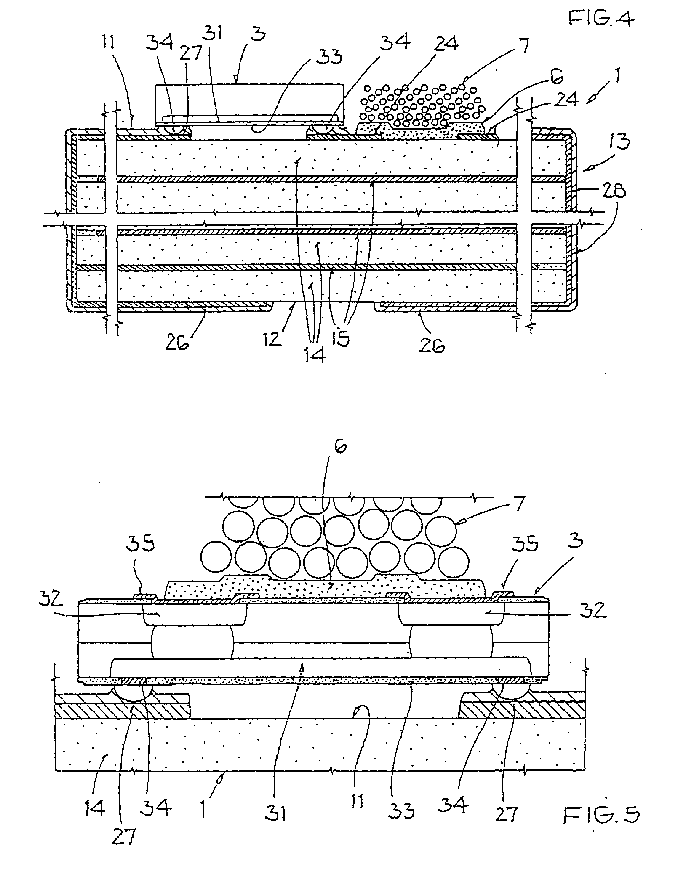

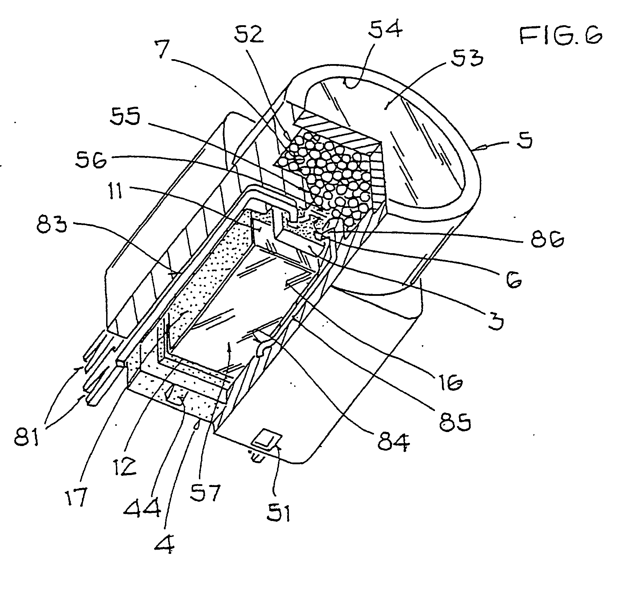

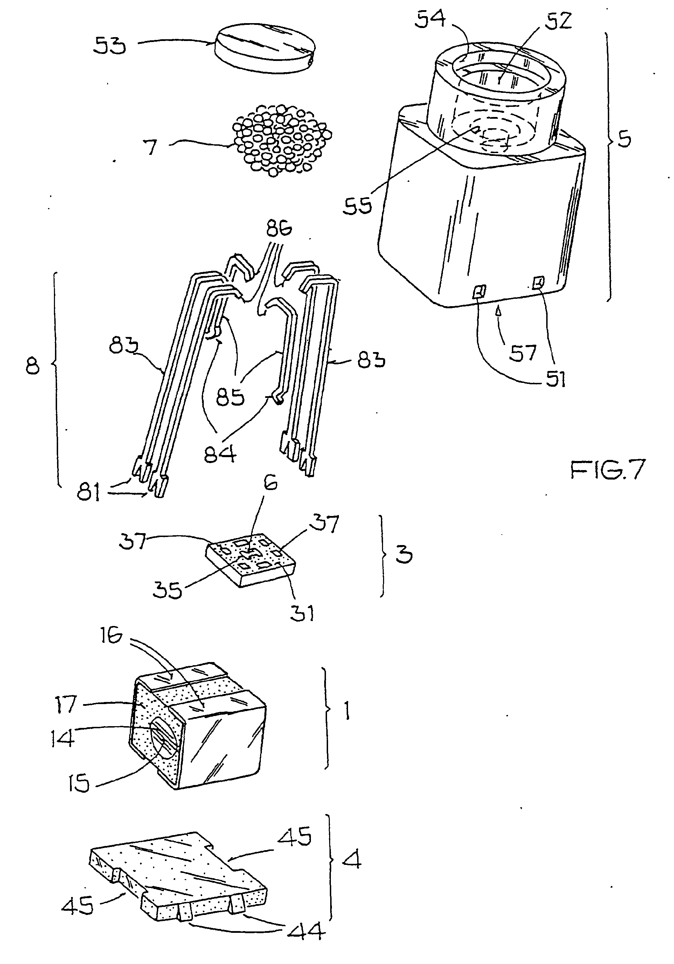

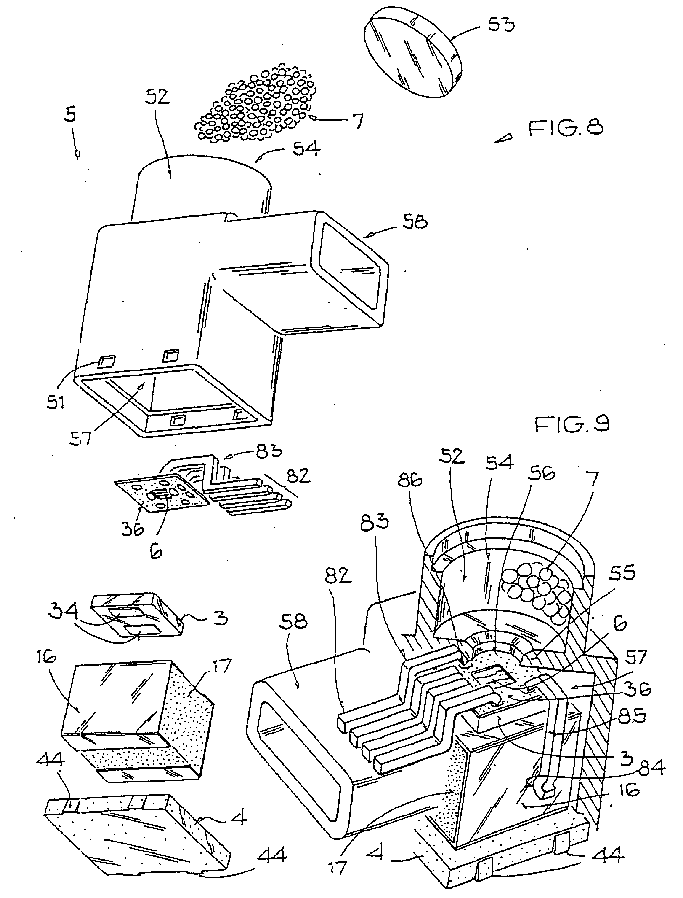

Jede der in den Figuren gezeigten Ausgestaltungen weist grundsätzlich folgende Grundkomponenten auf, eine Kondensatoranordnung 1, insbesondere einen Zündkondensator, eine Leiterbahnstruktur 2, Bauelemente, insbesondere einen Schaltkreis 3, ein Gehäuseunterteil 4, ein Gehäuseoberteil 5, eine Zündschicht 6 sowie eine Treibladung 7. Die Grundkomponenten wurden in allen Figuren mit den gleichen Bezugszeichen versehen und Details dieser Grundkomponenten im allgemeinen durch Ergänzung einer weiteren Ziffer bezeichnet.
Die Figur 1 zeigt zerlegt ein pyrotechnisches Zündsystem, wie es bspw. für den Einsatz in Gasgeneratoren von Insassenschutzsystemen vorgesehen ist. Das pyrotechnische Zündsystem besteht aus einer Zündschaltung bestehend aus einer Kondensatoranordnung 1, insbesondere dem Zündkondensator, Leitbahnen 2, einem Schaltkreis 3 und einer Zündschicht 6, an der durch Einprägen von elektrischer Energie ein Anzünden der separat dargestellten Treibladung 7 des Anzünders bewirkt wird.
Als Trägerelement für die Zündschaltung dient die Kondensatoranordnung 1 mit wenigstens einer der ebenen, selbst nicht leitfähigen Außenflächen 11,12,13, wobei in diesem Ausführungsbeispiel neben den Bauelementen auch die Leiterbahnstruktur 2 auf den Außenfläche(n) 11,12,13 angeordnet ist. Es wird gerade die Kondensatoranordnung 1 als Trägerelement verwendet, da gerade diese üblicherweise ebene, nicht leitfähige Außenflächen 11,12,13 und die größten Abmaße aller Bauelemente aufweist. Zudem wird eine solche Kondensatoranordnung 1 häufig aus dielektrischen Material, bspw. Keramik - Plattenkondensator ausgeführt, auf dem besonders einfach die Leitbahnen 2 in bekannter Dick- oder Dünnfilmtechnik oder auch durch Aufdampfen aufgebracht werden können.
Indem die Kondensatoranordnung 1 bestehend zumindest aus dem Zündkondensator als Trägerelement für die anderen Bauelemente 3 und die Leitbahnen 2 verwendet wird, entsteht eine äußerst kompakte und kleine Baugruppe, wie Figur 1 bereits erkennen läßt.
Dieses Zündsystem wird von einem zweiteiligen Gehäuse 4,5 umschlossen, wobei das Gehäuseunterteil 4 neben Fügehilfselementen 44 mit dem Gehäuseoberteil 5 eine Aufnahmekammer 41 für die Baugruppe und in diesem Ausführungsbeispiel kontaktzungenförmige Kontaktelemente 42 aufweist, über die das Zündsystem mit einem Anschlußkabel 43 verbindbar ist. Dazu weist die Kondensatoranordnung 1 auf der Unterseite 12 Kontaktzonen 26 auf, die in Figur 3 gezeigt werden. Hervorzuheben ist, daß die Kontaktelemente 42 damit direkt die aus der Leiterbahnstruktur ausgeformten Kontaktzonen 26 kontaktieren, es also keiner Stecker-Buchsen-Verbindungen oder ähnliches bedarf. Die Kontaktelemente 42 werden dabei druckdicht im Gehäuseunterteil 4 eingeschweißt bzw. von diesem umspritzt. Bevorzugt ist auch, daß das Zündsystem vom Gehäuse 4,5 druckdicht umschlossen wird, indem es maßgenau in die Aufnahmekammer 41,57 des Gehäuses 4,5 eingefügt und dort vorzugsweise durch Schweiß-, Löt- , Preß- , Crimp- oder Klebverbindungen arretiert wird. Die Druckdichtheit schützt einerseits das Zündsystem vor äußeren Einflüssen, insbesondere Feuchtigkeit und ermöglicht zudem beim Zünden einen Druckaufbau, der sich dann gezielt durch eine von einer Druckmembran 53 zunächst verschlossene Ausströmöffnung 54 im Gehäuseoberteil 5 entlädt.
Die Ausführungsbeispiele in den Figuren 1 bis 5 weisen Leitbahnen 21 auf der Kondensatoranordnung 1 auf, die in diesem Ausführungsbeispiel sowohl die weiteren Bauelemente 3 untereinander und mit der Kondensatoranordnung 1 sowie mit Anschlüssen 24 für die Zündschicht 6 verbinden, sowie zudem Leitbahnen 28, die an den Seitenflächen 13 der Kondensatoranordnung 1 angeordnet sind, wie in Figur 2 und 3 zu sehen ist. Diese verbinden elektrisch die auf der Oberseite 11 angeordneten Elemente, also Leitbahnen 21, Bauelemente 3 und Zündschicht 6 mit Kontaktzonen 26 auf der Unterseite 12 der Kondensatoranordnung 1.
Als Bauelemente ist in den Figur 1 bis 5 vereinfachend jeweils nur ein Schaltkreis 3 dargestellt. Jedoch können durchaus auch mehrere Schaltkreise und andere Bauelemente, bspw. Widerstände oder ähnliches so auf der Kondensatoranordnung 1 angeordnet werden.
Die Gehäuseoberseite 5 weist den Fügehilfselementen 44 der Gehäuseunterseite 4 zugeordnete Fügehilfselemente 51 (hier bspw. ausgebildet als Rasthaken und Rastöffnungen) sowie zudem eine Treibladungskammer 52 auf, in der die Treibladung 7 des Zündsystems angeordnet ist. Die Treibladungskammer 52 weist eine durch eine Druckmembran 53 zunächst verschlossene Ausströmöffnung 54 auf. Wird die Zündschicht 6 aktiviert und entzündet diese die pyrotechnische Treibladung 7, so baut sich innerhalb der Treibladungskammer 52 ein Druck auf, der die Druckmembran 53 aufreißt und heiße brennende Treibladungspartikel schlagartig und mit Druck durch die Ausströmöffnung 54 in den Gasgenerator strömen, wodurch dort eine natürlich deutlich größere und auf die Gaserzeugung optimierte Treibladung gezündet wird. Die Treibladungskammer 52 ist vorzugsweise von der Aufnahmekammer 41 für die Kondensatoranordnung 1 mit den Bauelementen durch eine Abtrennung 55 (siehe insb. Fig. 9) geschützt, die nur im Bereich der Zündschicht 6 eine Öffnung 56 aufweist.
Für einen Teil der Anwendungsgebiete dieser Zündsysteme sollen Kommunikationsschaltungen mit in das Gehäuse 4,5 integriert werden. Dazu können diese entweder auf der von der Zündschicht 6 und Treibladung 7 abgewandten Unterseite 12 der Kondensatoranordnung 1 angeordnet werden oder entsprechend für diese ja extrem kurze Zeitspanne ausreichend hitzebeständige Bauelemente und elektrische Verbindungen verwendet werden. In Figur 1 könnte bspw. in den IC 3 bereits eine solche Kommunikationsschaltung mit integriert sein, indem der IC 3 ausreichend geschützt bzw. druck - und hitzebeständig ist. Ein weitgehender Schutz der Schaltung ist schon durch die weitgehende Abtrennung 55 zwischen der Zündkammer 52 und der Aufnahmekammer 57/42 für die Kondensatoranordnung 1 möglich, wie dies in Zusammenhang mit nachfolgenden Figuren noch näher gezeigt wird.
Zudem ist in Figur 2 die Oberseite 11 des Zündkondensators 1 mit den Kontaktzonen 27 dargestellt, auf die der IC 3 bspw. mittels Flip-Chip-Technik aufgesetzt wird.
Die seitlich an der Kondensatoranordnung 1 verlaufenden Leitbahnen 28 sind in besonders bevorzugter Weise auch untereinander durch Funkenbrückenspitzen 22 gegen elektrostatische Entladungen geschützt, wie in Figur 2 und 3 zu erkennen ist. Die Leitbahnen 28 dienen des weiteren zur Verschaltung der einzelnen Kondensatorbeläge der Kondensatoranordnung 1 zu einem Kondensator aus mehreren Platten, wie in Figur 4 skizziert ist. Neben der Energiespeicherung kann die Kondensatoranordnung 1 auch weitere Funktionen haben, insbesondere als zwei voneinander elektrisch getrennte Kondensatoren verschaltet werden, von denen einer als Zündkondensator und der andere als Schutzkondensator gegen ESD, EMV und ähnliche elektrische Störungen verschaltet ist.
Die Schnittdarstellung in Figur 4 verdeutlicht noch einmal die Funktion der auf den Seitenflächen 13 angeordneten Leitbahnen 28 zur Verschaltung der einzelnen parallelen voneinander durch dielektrisches Material, vorzugsweise Keramikplatten 14 getrennten Kondensatorplattenbeläge15 hin zu einer bzw. auch zwei Kondensatoren.
Im Schnitt des IC 3 in Figur 4 bzw. 5 sind die aktive Zone 31, in die die Transistoren und ähnliches integriert sind, sowie eine Isolationsschicht 33, bspw. aus Siliziumoxid mit Kontaktzonen 34, bspw. aus aufgedampftem Aluminium, ausgerichtet entsprechend auf die zugeordneten Kontaktzonen 27 auf der Kondensatoranordnung 1 skizzenhaft angedeutet.
Das Zündmittel ist im Ausführungsbeispiel in Figur 4 als separat auf die Zündbrückenanschlüsse 24 bspw. per Dickfilmtechnik aufzutragende Zündschicht 6 dargestellt, wobei diese Schicht auch einstückig mit den Anschlüssen aus einem entsprechenden Material, bspw. Widerstandsmaterial, dotiertem Silizium oder ähnlichem ausgebildet sein kann.
In dieser Figur wird die Zündbrückenschicht 6 neben dem IC 3 angeordnet und über Leitbahnen 21 und daraus ausgeformte Anschlüsse 24 mit den anderen Bauelementen, insbesondere dem IC 3 und der Kondensatoranordnung 1 verbunden.
Alternativ dazu kann die Zündschicht 6 auch im oder auf dem IC 3 angeordnet werden, wie dies in Figur 5 dargestellt ist. In dieser Figur sind ebenfalls nur skizzenhaft die halbleitertechnisch strukturierte aktive Schicht 31 sowie die Isolationsschicht 33 gezeigt, wobei in diesen Querverbindungen 32 von der Oberseite der aktiven Schicht 31 oder der Isolationsschicht 33 hin zu Anschlüssen 35 für die Zündschicht 6 auf der bei Face-Down-Montage oben liegenden Unterseite des IC 3 vorgesehen sind. Gerade in diesem Fall kann aber auch die Zündschicht 6 in das Substrat des als Nacktchip ausgebildeten IC 3 durch entsprechende Dotierung eingebracht und die Anschlüsse 35 ebenfalls integriert ausgebildet werden.
Die Figuren 6 bis 9 zeigen nun weitere Ausgestaltungen, bei denen eine konventionelle Kondensatoranordnung mit einem eigenen Gehäuse 17 verwendet und die Leiterbahnstruktur 2 durch metallische Einlegeteile 83, 85 gebildet wird.
Gemeinsam mit den vorangegangenen Figuren ist wiederum in einer Aufnahmekammer des Gehäuses, hier im Gehäuseoberteil 5 ausgebildet und als 57 bezeichnet, die Kondensatoranordnung 1 und auf einer nicht leitfähigen Außenfläche von diesem der Schaltkreis 3 angeordnet.
Die Kondensatoranordnung 1 ist konventionell, d.h. als handelsüblicher Kondensator mit einem eigenen Gehäuse 17 ausgebildet. Vorteil dieser Ausgestaltung ist, daß im Gegensatz zu der mit Leiterbahnstrukturen versehenen Kondensatoranordnung aus den Figuren 1 bis 5 nun ein sehr preiswerter Standardkondensator verwendet wird, auf den in gleicher Weise die Bauelemente, insbesondere der Schaltkreis 3 angeordnet, bspw. aufgeklebt sind.
Die Kondensatoranordnung 1 umfaßt in diesem Beispiel nur die Zündkondensatorfunktion und weist zwei voneinander isolierte elektrische Kontaktflächen 16 beispielsweise an den Seitenflächen auf, über die die Kondensatorbeläge im Inneren verschaltet sind. Das Gehäuse 17 der Kondensatoranordnung 1 ist beispielsweise durch eine Umspritzung mit Isolationsmaterial gebildet. Die Kontaktflächen 16 können auch auf die zum Schaltkreis 3 gerichtete Oberseite der Kondensatoranordnung 1 gezogen sein, wie in Fig. 7 gezeigt, so daß die Kondensatoranordnung 1 auch durch Kontaktzonen 34 (siehe Fig. 8, vergleichbar denen aus Fig. 4) auf der Unterseite des Schaltkreises 3 direkt mit dem Schaltkreis 3 verbunden ist, so daß die dafür in Fig. 6, 7 und 9 vorgesehenen Einlegeteile 85 entfallen können. Diese Kontaktzonen 34 auf der Unterseite des Schaltkreises 3 könnten über Durchkontaktierungen vergleichbar denen mit Bezugszeichen 32 aus Fig. 5 oder durch am Schaltkreis 3 außen entlang geführte Bahnen mit der Oberseite des Schaltkreises 3 verbunden sein. Stehen die einzelnen Platten der Kondensatoranordnung senkrecht bezüglich dem Gehäuseunterteil 4, könnte beispielsweise auch nur diejenige dann zum Schaltkreis 3 zeigende Kontaktfläche 16 über einen Substratanschluß des Schaltkreises 3, bspw. durch Löten oder Leitkleber, sowohl mechanisch befestigt als auch elektrisch kontaktiert sein.
Das Gehäuseoberteil 5 wird durch ein Gehäuseunterteil 4 verschlossen, wobei die Fügehilfselemente 44, 51 ineinander greifen und beide Gehäuseteile 4, 5 miteinander arretieren. Vorzugsweise durch eine Abtrennung 55 von der Aufnahmekammer 57 getrennt befindet sich die Treibladungskammer 52 mit der Treibladung 7, wobei die Abtrennung 55 im Bereich der
Zündschicht 6 eine Öffnung 56 aufweist, durch die die Zündschicht 6 die Treibladung 7 entzünden kann. Die Treibladungskammer 52 weist wiederum eine durch einen Druckdeckel 53 zunächst verschlossene Ausströmöffnung 54 bspw. zu einem nicht mehr dargestellten Gasgenerator eines Airbags auf. Die Kompaktheit des Zündsystems basiert wiederum auf der grundlegenden Anordnung der Bauelemente, insbesondere des Schaltkreises 3 direkt auf der Kondensatoranordnung 1.
Die Einlegeteile 83, 85 sind vorzugsweise einstückig aus Metallband gestanzt sowie in die entsprechende Form gebogen und im Material des Gehäuseoberteils 5 durch Umspritzen fixiert, wobei an den Enden der Einlegeteile Kontaktbereiche 81,82,84,86 frei bleiben. Für die Einlegeteile 83 wird ein Ende ins Äußere des Gehäuse geführt, wo er dort ausgebildet ist als Schneid-KlemmKontakte 81 in Fig. 6,7 für die direkte Kontaktierung eines isolierten Kabels oder als Steckkontakte 82 in Fig. 8,9 für die Kontaktierung mit einem nicht näher gezeigten Stecker. Des weiteren sind in Fig. 9 die Einlegeteile 85 zur Kondensatoranordnung 1 mit auf die elektrischen Kontaktflächen 16 der gehäusten Kondensatoranordnung hin gerichteten Kontakten 84 vorgesehen. Diese Einlegeteile 85 sind in Fig. 8 durch den direkten elektrischen Kontakt der Kontaktzonen 34 des Schaltkreises 3 mit den Kontaktflächen 16 der Kondensatoranordnung 1 ersetzt.
Die anderen Enden 86 der Einlegeteile 83 und 85 kontaktieren jeweils den Schaltkreis 3. Hervorzuheben ist auch die besondere Ausformung der inneren Kontaktenden 86 und 84, denn diese sind vorzugsweise aus dem Gehäuse federelastisch hervorstehend ausgebildet, so daß beim Einführen der Kondensatoranordnung 1 mit dem darauf angeordneten Schaltkreis 3 in das Gehäuseoberteil 5 und Verschließen des Gehäuses durch das Gehäuseunterteil 4, die Kondensatoranordnung 1 mit dem darauf angeordneten Schaltkreis 3 gegen die Kontaktenden 86 und 84 der Einlegeteile 83,85 gedrückt werden. Neben einer mechanischen Fixierung wird so auch ein sicherer elektrischer Kontakt gewährleistet. Neben einer anderen Ausgestaltung der äußeren Kontaktenden als Pins 82 in einem Steckerbereich 58 des Gehäuseoberteils 5 weisen die Figuren 8 und 9 als Besonderheit noch eine Kontaktfolie 36 auf, beispielsweise mit einem lokalen Auftrag von Leitkleber, wobei die Kontaktfolie 36 auf den Schaltkreis 3 aufgebracht den Kontakt zwischen diesem und den inneren Kontaktenden 86 und 84 der Einlegeteile 83, 85 verbessert.
Diese Kontaktfolie 36 trägt entweder selbst eine Zündschicht 6 , wie in Fig. 8, oder weist eine Aussparung für die darunter liegende Zündschicht 6, wie in Fig. 9.
Die Zündschicht 6 kann dabei grundsätzlich sowohl auf dem Schaltkreis 3 als auch auf der Kondensatoranordnung 1 angeordnet sein, wie bereits anhand der Ausführungsbeispiele in den Figuren 4 und 5 erläutert wurde.
Grundsätzlich können die Einlegeteile 83, 85 auch am Gehäuse innen befestigt oder durch metallisierte Bahnen ausgebildet auf der Oberfläche der Aufnahmekammer 57 ausgebildet sein.
Die Gehäuseteile 4 und 5 werden vorzugsweise miteinander druckdicht und feuchtigkeitsundurchlässig verbunden. Das Gehäuseunterteil 4 in Figur 6 und 7 weist dabei Aussparungen 45 zur Durchführung der Einlegeteile 85 auf und wird zur Abdichtung dann bspw. durch eine Gußmasse aufgefüllt.
Besonders gut zu erkennen ist in Figur 9 auch die Abtrennung 55 zwischen der Treibladungskammer 52 und der Aufnahmekammer 57 für die Kondensatoranordnung 1 mit dem Schaltkreis 3. Die Abtrennung 55 kann einstückig aus dem Gehäuseoberteil 5 ausgebildet sein, welches bspw. durch temperaturbeständigen Kunststoffspritzguß herstellbar ist. Die Abtrennung 55 dient dem Schutz des Schaltkreises 3 gegen die Temperatur- und Druckeinwirkung bei dem explosionshaften Abbrand der Treibladung 7. die Abtrennung 55 ist nur durch eine Öffnung 56 direkt über der Zündschicht 6 unterbrochen, damit die Zündschicht 6 die Treibladung 7 zünden kann.

### Bezugszeichenliste:

- 1: Kondensatoranordnung
- 11: Oberseite der Kondensatoranordnung 1
- 12: Unterseite der Kondensatoranordnung 1
- 13: Seitenfläche der Kondensatoranordnung 1
- 14: Isolationsplatten
- 15: Kondensatorbeläge
- 16: elektrische Kontaktflächen eines konventionellen Kondensators 1
- 17: Gehäusellsolafionsumspritzung des Kondensators 1

- 2: Leitbahnstruktur, aufgedampft auf der Kondensatoranordnung
- 21: elektrische Leitbahnen zwischen den Bauelementen
- 22: ESD-Brückenspitzen
- 23: -
- 24: Zündbrückenanschlüsse ausgeformt- aus der Leiterbahnstruktur auf der Kondensatoranordnung
- 25: -
- 26: Kontaktzonen zu den Kontaktzungen 42 im Gehäuseunterteil 4
- 27: Kontaktzonen zum IC 3
- 28: seitliche Leitbahnen

- 3: integrierter Schaltkreis als Bauelement auf der Kondensatoranordnung 1
- 31: aktive Schicht des IC
- 32: Durchkontaktierung von der Unterseite auf die Oberseite des IC 3
- 33: isolationsschicht mit Verbindungen zu den Kontaktzonen 34
- 34: Kontaktzonen des IC 3 zu den Kontaktzonen 27 der Kondensatoranordnung 1
- 35: Anschlüsse für die Zündbrücke 6 auf dem IC 3
- 36: Kontaktfolie zwischen IC 3 und den Einlegeteilen 83, 85
- 37: Kontaktzonen des IC 3 zu den Einlegeteilen

- 4: Gehäuseunterteil
- 41: Aufnahmekammer im Gehäuseunterteil 4 für Kondensatoranordnung 1 und Bauelemente 3
- 42: Kontaktzungen im Gehäuseunterteil 4 zu den Kontaktzonen 26 auf der Unterseite 12 der Kondensatoranordnung 1
- 43: Verbindungskabel
- 44: Rastelemente am Gehäuseunterteil
- 45: Aussparung im Gehäuseunterteil zur Durchführung der Einlegeteile 83

- 5: Gehäuseoberteil
- 51: Rastelemente am Gehäuseoberteil
- 52: Treibladungszündkammer
- 53: Druckmembran
- 54: Ausströmöffnung zum Gasgenerator
- 55: Abtrennung zwischen Zündkammer und Aufnahmekammer für Kondensatoranordnung und IC
- 56: Öffnung in der Abtrennung 55 der Kammern 52/57 über der Zündschicht 6
- 57: Aufnahmekammer für Kondensatoranordnung 1 und Bauelemente 3 im Gehäuseoberteil 5
- 58: Steckerbereich, ausgeformt aus dem Gehäuseoberteil 5

- 6: Zündschicht

- 7: Treibladung des Anzünders

- 8: Einlegeteile als Leitbahnstruktur
- 81: Schneid-Klemm-Anschlüsse für äußere Kabel
- 82: stiftförmig ausgeformte Anschlüsse (Pins) für einen Stecker
- 83: metallische Einlegeteile mit ausgeformten äußeren Anschlüssen 81,82
- 84: innere Kontaktenden zur den Kontaktflächen 16 der Kondensatoranordnung 1
- 85: metallische Einlegeteile im Gehäuse 5 mit Kontaktenden 84 zur Kondensatoranordnung 1
- 86: federelastisch hervorstehende Kontaktenden zum Schaltkreis 3

## Patentansprüche

1. Pyrotechnisches Zündsystem mit integrierter Zündschaltung, insbesondere zum Auslösen eines Insassenrückhaltesystems, bestehend aus:
miteinander elektrisch über eine Leiterbahnstruktur (2,8) verbundenen Bauelementen (1,3) innerhalb eines Gehäuses (4,5) und
einem mittels einer Zündspannung zündbaren Zündmittel (6), welches seinerseits eine pyrotechnische Treibladung (7) zündet, wobei die Zündspannung von den Bauelementen (1,3) erzeugt und/oder gespeichert und/oder geschaltet wird,
**dadurch gekennzeichnet, daß**
eines der elektrischen Bauelemente (1) zumindest eine ebene, zumindest bereichsweise selbst nichtleitfähige Außenfläche aufweist und
dieses Bauelement mit seiner ebenen, selbst nichtleitfähigen Außenfläche als Trägerelement für die anderen Bauelemente (3) dient, indem die anderen Bauelemente (3) auf der Außenfläche angeordnet sind.

2. Pyrotechnisches Zündsystem nach Anspruch 1, **dadurch gekennzeichnet, daß** als Trägerelement eine Kondensatoranordnung (1) dient, auf deren zumindest bereichsweise nicht leitfähiger Außenfläche zumindest ein Schaltkreis (3) angeordnet ist.

3. Pyrotechnisches Zündsystem nach Anspruch 2, **dadurch gekennzeichnet, daß** die Leiterbahnstruktur (8) durch metallische Einlegeteile (83,85) im Gehäuse (5) ausgebildet ist.

4. Pyrotechnisches Zündsystem nach Anspruch 2, **dadurch gekennzeichnet, daß** die Leiterbahnstruktur (2) zumindest teilweise auf den nicht leitfähigen Außenflächen (11,12,13) angeordnet, insbesondere aufgedampft, abgeschieden oder aufgeklebt ist.

5. Pyrotechnisches Zündsystem nach einem der vorangehenden Ansprüche 2 bis 4, **dadurch gekennzeichnet, daß** das Zündmittel als Zündschicht (6) auf der Oberseite des Schaltkreises (3) angeordnet ist.

6. Pyrotechnisches Zündsystem nach einem der vorangehenden Ansprüche 2 bis 4, **dadurch gekennzeichnet, daß** das Zündmittel als Zündschicht (6) auf der Kondensatoranordnung (1) angeordnet und aus der Leiterbahnstruktur (2) Kontaktgebiete (24) zu dieser Zündschicht (6) ausgeformt sind.

7. Pyrotechnisches Zündsystem nach Anspruch 2, **dadurch gekennzeichnet, daß** die als Trägerelement verwendete Kondensatoranordnung (1) zur Speicherung der Zündenergie als Zündkondensator verschaltet ist.

8. Pyrotechnisches Zündsystem nach Anspruch 2, **dadurch gekennzeichnet, daß** die als Trägerelement verwendete Kondensatoranordnung (1) aus zwei voneinander elektrisch getrennten Kondensatoren besteht, von denen ein Kondensator als Zündkondensator und der andere als Schutzkondensator gegen elektrische Störungen verschaltet ist.

9. Pyrotechnisches Zündsystem nach Anspruch 3, **dadurch gekennzeichnet, daß** auf der Oberseite des Schaltkreises (3) Kontaktzonen (37) ausgeformt sind, an denen der Schaltkreis (3) über die metallischen Einlegeteile (83,85) mit äußeren Anschlüssen (81,82) und/oder mit der Kondensatoranordnung (1) verbunden ist.

10. Pyrotechnisches Zündsystem nach Anspruch 9, **dadurch gekennzeichnet, daß** die Einlegeteile (83,85) im Gehäuse (5) durch Umspritzen befestigt sind.

11. Pyrotechnisches Zündsystem nach Anspruch 10, **dadurch gekennzeichnet, daß**
a) das Gehäuse (4,5) zweiteilig ausgeführt ist und der eine Gehäuseteil (5) eine Aufnahmekammer (57) für die Kondensatoranordnung (1) mit dem darauf angeordneten Schaltkreis (3) aufweist,
b) in diesem Gehäuseteil (5) Kontaktenden (86,84) der Einlegeteile (83,85) in diese Aufnahmekammer (57) hineinragen und
c) die Kondensatoranordnung (1) mit dem darauf angeordneten Schaltkreis (3) durch das andere Gehäuseteil (4) gegen die Kontaktenden (86,84) der Einlegeteile (83,85) gedrückt werden.

12. Pyrotechnisches Zündsystem nach Anspruch 11, **dadurch gekennzeichnet, daß** die Kontaktenden (86,84) der Einlegeteile (83,85) federelastisch ausgebildet sind.

13. Pyrotechnisches Zündsystem nach Anspruch 11, **dadurch gekennzeichnet, daß** die Kontaktenden (86) der Einlegeteile (83,85) und die zugehörigen Kontaktzonen (37) auf dem Schaltkreis (3) mit einem Leitkleber oder reflowgelötetem Lot verbunden sind.

14. Pyrotechnisches Zündsystem nach Anspruch 11, **dadurch gekennzeichnet, daß** zwischen den die Kontaktenden (86) der Einlegeteile (83,85) und den zugehörigen Kontaktzonen (37) auf dem Schaltkreis (3) eine flexible Folie (36) vorgesehen ist, die beidseitig Leitkleber oder reflowgelötetes Lot sowie elektrische Verbindungen zwischen den Seiten der Folie aufweist.

15. Pyrotechnisches Zündsystem nach Anspruch 12, **dadurch gekennzeichnet, daß** das Zündmittel als Zündschicht (6) auf der flexiblen Folie auf dem Schaltkreis (3) angeordnet ist.

16. Pyrotechnisches Zündsystem nach einem der vorangehenden Ansprüche 9 bis 15, **dadurch gekennzeichnet, daß** die Kondensatoranordnung als ein Standardkondensator mit einem Gehäuse (17) mit wenigstens einer ebenen Außenfläche und elektrischen Kontaktflächen (16) ausgebildet ist, wobei der Schaltkreis (3) über die metallischen Einlegeteile (85) mit den elektrischen Kontaktflächen (16) verbunden ist.

17. Pyrotechnisches Zündsystem nach Anspruch 9, **dadurch gekennzeichnet, daß** zumindest eine Gruppe von Einlegeteilen (83) aus dem Gehäuse herausgeführt ist und dort aus den Einlegeteilen (83) die äußeren Anschlüsse (81,82) einstückig ausgeformt sind.

18. Pyrotechnisches Zündsystem nach Anspruch 18, **dadurch gekennzeichnet, daß** die einstückig aus den Einlegeteilen (83) ausgeformten äußeren Anschlüsse als Schneid-Klemmkontakte (81) ausgeformt sind.

19. Pyrotechnisches Zündsystem nach Anspruch 18, **dadurch gekennzeichnet, daß** die einstückig aus den Einlegeteilen (83) ausgeformten äußeren Anschlüsse als Anschlußstifte (82) ausgeformt sind.

20. Pyrotechnisches Zündsystem nach Anspruch 4, **dadurch gekennzeichnet, daß** aus der Leiterbahnstruktur (2) auf der Kondensatoranordnung (1) Kontaktzonen (27) ausgeformt sind, an die zugeordnete Kontaktzonen (34) auf der anliegenden Seite des Schaltkreises (3) angeschlossen sind.

21. Pyrotechnisches Zündsystem nach Anspruch 20, **dadurch gekennzeichnet, daß** der Schaltkreis (3) über die Kontaktzonen (34) auf der Kondensatoranordnung (1) in Flip-Chip-Technik angeordnet ist.

22. Pyrotechnisches Zündsystem nach Anspruch 4, **dadurch gekennzeichnet, daß**
a) die Kondensatoranordnung (1) als Plattenkondensatoranordnung ausgeführt ist mit mehreren dielektrischen Isolationsplatten (14), auf denen zumindest teilweise metallische Kondensatorbeläge (15) abgeschieden sind,
b) wobei auf der/den Außenseite(n) (11,12) der äußeren Platte(n) Leitbahnen (21) aufgetragen sind und
c) auf den Seitenflächen (13) senkrecht zu den Kondensatorplatten weitere, seitliche Leitbahnen (28) angeordnet sind und über diese seitlichen Leitbahnen (28) die einzelnen Kondensatorbeläge (15) untereinander zu mindestens einem Kondensator sowie mit den anderen elektrischen Bauelementen (3) verschaltet sind.

23. Pyrotechnisches Zündsystem nach Anspruch 4, **dadurch gekennzeichnet, daß** aus der Leiterbahnstruktur (2) eine Funkenstrecke (22) und/oder ein elektrischer Widerstand zur Entladung von elektrostatischen Aufladungen ausgebildet ist.

24. Pyrotechnisches Zündsystem nach Anspruch 4, **dadurch gekennzeichnet, daß** eine außerhalb des Gehäuses angeordnete Auslöseelektronik über eine elektrische Verbindung (43) mit dem Zündsystem verbunden ist, wobei innerhalb am Gehäuse (4) Kontaktelemente (42) vorgesehen sind, die aus der Leiterbahnstruktur (2) ausgeformte Kontaktzonen (26) direkt kontaktieren.

25. Pyrotechnisches Zündsystem nach Anspruch 6, **dadurch gekennzeichnet, daß** auf der Oberseite von dem Schaltkreis (3) das Zündmittel mit zwei voneinander isolierten Kontaktgebieten ausgeführt ist, die über eine pyrotechnische Zündschicht (6) untereinander verbunden sind.

26. Pyrotechnisches Zündsystem nach Anspruch 6, **dadurch gekennzeichnet, daß** das Zündmittel als Halbleiterbrückenanzünder ausgebildet ist und die Kontaktgebiete (35) zur Zündschicht (6) auf der Oberseite von dem unverpackt ausgeführten Schaltkreis (3) durch voneinander isolierte leitfähig dotierte Gebiete ausgestaltet sind.

27. Pyrotechnisches Zündsystem nach einem der Ansprüche 2 bis 26, **dadurch gekennzeichnet, daß** die Kondensatoranordnung (1), der Schaltkreis (3) und das Gehäuse (4,5) druckdicht verschlossen ist, insbesondere mittels Schweiß-, Löt-, Preß-, Crimp- oder Klebverbindung.

28. Pyrotechnisches Zündsystem nach einem der Ansprüche 2 bis 27, **dadurch gekennzeichnet, daß** das Gehäuse (4,5) zwischen der Aufnahmekammer (57,42) für die Kondensatoranordnung (1) mit dem Schaltkreis (3) und einer Treibladungskammer (52), in der die Treibladung (7) angeordnet ist, eine Abtrennung (55) aufweist, die nur durch eine Öffnung (56) über dem Zünder (6) unterbrochen ist, durch die der Zünder (6) die Treibladung (7) zündet.

## Claims

1. Pyrotechnical ignition system with integrated firing circuit, in particular for activating a passenger restraint system consisting of:
components (1, 3) which are electrically inter-connected within a housing (4, 5) via a conductor track structure (2, 8) and
an igniter (6) which is ignitable by means of an ignition voltage and which in turn ignites a pyrotechnical propellant (7) with the ignition voltage being generated and/or stored and/or fired by the components (1, 3),
**characterised in that**
one of the electrical components (1) comprises at least one plane outer surface which at least in certain areas is non-conductive itself and
this component with its plane outer surface which is non-conductive itself serves as a carrier element for the other components (3), the other components (3) being arranged on the outer surface.

2. Pyrotechnical ignition system according to claim 1 **characterised in that** a capacitor arrangement (1) serves as carrier element on the outer surface of which, which is non-conductive at least in certain areas, at least one circuit (3) is arranged.

3. Pyrotechnical ignition system according to claim 2 **characterised in that** the conductor track structure (8) is formed within the housing (5) by means of metallic inserts (83, 85).

4. Pyrotechnical ignition system according to claim 2 **characterised in that** the conductor track structure (2) is arranged at least in part on the non-conductive outer surfaces (11, 12, 13), in particular vapour-deposited, deposited or pasted thereon.

5. Pyrotechnical ignition system according to any of the preceding claims 2 to 4 **characterised in that** the igniter is arranged as an igniting layer (6) on the top surface of the circuit (3).

6. Pyrotechnical ignition system according to any of the preceding claims 2 to 4 **characterised in that** the igniter is arranged as an igniting layer (6) on the capacitor arrangement (1) and that contact areas (24) to the said igniting layer (6) are formed from the conductor track structure (2).

7. Pyrotechnical ignition system according to claim 2 **characterised in that** the capacitor arrangement (1) which is used as carrier element is connected as ignition capacitor for the storage of the ignition energy.

8. Pyrotechnical ignition system according to claim 2 **characterised in that** the capacitor arrangement (1) which is used as carrier element consists of two capacitors which are electrically separated from each other with one of the capacitors being connected as ignition capacitor and the other one as protective capacitor against electrical interference.

9. Pyrotechnical ignition system according to claim 3 **characterised in that** contact zones (37) are formed on the top surface of circuit (3) at which the circuit (3) is connected via the metallic inserts (83, 85) with external terminals (81, 82) and/or with the capacitor arrangement (1).

10. Pyrotechnical ignition system according to claim 9 **characterised in that** the inserts (83, 85) are attached within the housing (5) by means of injection-moulding.

11. Pyrotechnical ignition system according to claim 10 **characterised in that**
a) the housing (4,5) is provided as a two-part housing and that the one housing part (5) comprises a receiving chamber (57) for the capacitor arrangement (1) with the circuit (3) being arranged thereon;
b) contact ends (86,84) of the inserts (83,85) project in this housing part (5) into the said receiving chamber (57), and
c) the capacitor arrangement (1) with the circuit (3) arranged thereon is pressed by the other housing part (4) against the contact ends (86,84) of the inserts (83,85).

12. Pyrotechnical ignition system according to claim 11 **characterised in that** the contact ends (86, 84) of the inserts (83, 85) are formed as spring-elastic ends.

13. Pyrotechnical ignition system according to claim 11 **characterised in that** the contact ends (86) of the inserts (83,85) and the associated contact zones (37) on the circuit (3) are interconnected by means of a conductive bonding agent or a reflow soldered solder.

14. Pyrotechnical ignition system according to claim 11 **characterised in that** between the contact ends (86) of the inserts (83, 85) and the associated contact zones (37) on circuit (3) a flexible foil (36) is provided comprising on both sides a conductive bonding agent or a reflow soldered solder as well as electrical connections between the sides of the foil.

15. Pyrotechnical ignition system according to claim 12 **characterised in that** the igniter is arranged as an igniting layer (6) on the flexible foil on the circuit (3).

16. Pyrotechnical ignition system according to any of the preceding claims 9 to 15 **characterised in that** the capacitor arrangement is provided as a standard capacitor with a housing (17) with at least one plane outer surface and electrical contact surfaces (16) with circuit (3) being connected with the electrical contact surfaces (16) via the metallic inserts (85).

17. Pyrotechnical ignition system according to claim 9 **characterised in that** at least a group of inserts (83) is extending from the housing and that there the external terminals (81, 82) are integrally formed from the inserts (83).

18. Pyrotechnical ignition system according to claim 18 **characterised in that** the external terminals which are integrally formed from the inserts (83) are provided as insulation displacement contacts (81).

19. Pyrotechnical ignition system according to claim 18 **characterised in that** the external terminals which are integrally formed from the inserts (83) are provided as terminal pins (82).

20. Pyrotechnical ignition system according to claim 4 **characterised in that** contact zones (27) are formed from the conductor track structure (2) on the capacitor arrangement (1) to which associated contact zones (34) on the adjacent side of the circuit (3) are connected.

21. Pyrotechnical ignition system according to claim 20 **characterised in that** the circuit (3) is arranged in flip-chip technique on the capacitor arrangement (1) via the contact zones (34).

22. Pyrotechnical ignition system according to claim 4 **characterised in that**
a) the capacitor arrangement (1) is provided as a plate-type capacitor arrangement with several dielectric insulation plates (14) on which at least in part metallic capacitor films (15) are deposited,
b) conducting tracks (21) are provided on the outer surface/surfaces (11,12) of the external plate/plates, and
c) additional, lateral conducting tracks (28) are arranged on the lateral faces (13) perpendicular to the capacitor plates and that via the said lateral conducting tracks (28) the individual capacitor films (15) are connected with each other to at least one capacitor as well as to the other electrical components (3).

23. Pyrotechnical ignition system according to claim 4 **characterised in that** a sparking distance (22) and/or an electrical resistance for the discharge of electrostatic charging is formed from the conductor track structure (2).

24. Pyrotechnical ignition system according to claim 4 **characterised in that** an electronic trigger device which is arranged outside the housing is connected with the ignition system via an electrical connection (43), with contact elements (42) being provided within the housing (4) which get into direct contact with contact zones (26) which are formed from the conductor track structure (2).

25. Pyrotechnical ignition system according to claim 6 **characterised in that** the igniter is provided on the top surface of circuit (3) with two contact areas which are insulated from each other and which are interconnected via a pyrotechnical igniting layer (6).

26. Pyrotechnical ignition system according to claim 6 **characterised in that** the igniter is configured as a semiconductor bridge igniter and that the contact areas (35) to the igniting layer (6) on the top surface of the unpacked circuit (3) are provided as conductive areas which are insulated from each other.

27. Pyrotechnical ignition system according to any of the claims 2 to 26 **characterised in that** the capacitor arrangement (1), the circuit (3) and the housing (4, 5) are pressure-sealed, in particular by means of welding joints, soldering joints, compression joints, crimp connections or glued joints.

28. Pyrotechnical ignition system according to any of the claims 2 to 27 **characterised in that** the housing (4, 5) comprises, between the receiving chamber (57, 42) for the capacitor arrangement (1) with circuit (3) and a propellant chamber (52) in which the propellant (7) is located, a separation (55) which is only interrupted by an opening (56) above the igniter (6) through which the igniter (6) ignites the propellant (7).

## Revendications

1. Système d'allumage pyrotechnique avec circuit d'allumage intégré, en particulier pour le déclenchement d'un système de retenue d'occupants, composé :
de composants (1, 3) connectés électriquement entre eux via une structure de piste conductrice (2, 8), à l'intérieur d'un boîtier (4, 5) et
d'un moyen d'allumage (6) pouvant être allumé au moyen d'une tension d'allumage, lequel moyen allume de son côté une charge propulsive pyrotechnique (7), la tension d'allumage étant produite et/ou stockée et/ou commutée par les composants (1, 3),
**caractérisé en ce que**
un des composants électriques (1) présente au moins une surface extérieure plane, non électriquement conductrice elle-même, au moins par secteurs, et
ce composant, avec sa surface extérieure plane, non électriquement conductrice elle-même, sert d'élément support pour les autres composants (3), les autres composants (3) étant disposés sur la surface extérieure.

2. Système d'allumage pyrotechnique selon la revendication 1, **caractérisé en ce qu'**un dispositif de condensateur (1) sert d'élément support, et **en ce que** au moins un circuit de commande (3) est disposé sur la surface extérieure non électriquement conductrice elle-même, au moins par secteurs.

3. Système d'allumage pyrotechnique selon la revendication 2, **caractérisé en ce que** la structure de piste conductrice (8) est constituée par des pièces d'insertion métalliques (83, 85) dans le boîtier (5).

4. Système d'allumage pyrotechnique selon la revendication 2, **caractérisé en ce que** la structure de piste conductrice (2) est disposée, en particulier par métallisation sous vide, par dépôt ou par collage, au moins partiellement sur les surfaces extérieures (11, 12, 13) non conductrices.

5. Système d'allumage pyrotechnique selon une des revendications précédentes 2 à 4, **caractérisé en ce que** le moyen d'allumage est disposé en tant que couche d'allumage (6) sur le côté supérieur du circuit de commande (3).

6. Système d'allumage pyrotechnique selon une des revendications précédentes 2 à 4, **caractérisé en ce que** le moyen d'allumage est disposé en tant que couche d'allumage (6) sur le dispositif de condensateur (1), et **en ce que** des secteurs de contact (24) conduisant à cette couche d'allumage (6) sont formés à partir de la structure de piste conductrice (2).

7. Système d'allumage pyrotechnique selon la revendication 2, **caractérisé en ce que** le dispositif de condensateur (1) utilisé comme élément support est câblé en tant que condensateur d'allumage pour le stockage de l'énergie d'allumage.

8. Système d'allumage pyrotechnique selon la revendication 2, **caractérisé en ce que** le dispositif de condensateur (1) utilisé comme élément support se compose de deux condensateurs séparés électriquement l'un de l'autre, dont un condensateur est câblé en tant que condensateur d'allumage, et l'autre est câblé en tant que condensateur de protection contre les perturbations électriques.

9. Système d'allumage pyrotechnique selon la revendication 3, **caractérisé en ce que**, sur le côté supérieur du circuit de commande (3), il est formé des zones de contact (37) au niveau desquelles le circuit de commande (3) est, via les pièces d'insertion métalliques (83, 85), connecté à des connexions extérieures (81, 82) et/ou au dispositif de condensateur (1).

10. Système d'allumage pyrotechnique selon la revendication 9, **caractérisé en ce que** les pièces d'insertion (83, 85) sont fixées dans le boîtier (5) par injection.

11. Système d'allumage pyrotechnique selon la revendication 10, **caractérisé en ce que**
a) le boîtier (4, 5) est exécuté en deux parties, et une partie de boîtier (5) présente une chambre de réception (57) pour le dispositif de condensateur (1) avec le circuit de commande (3) disposé dessus,
b) dans cette partie de boîtier (5), des extrémités de contact (86, 84) des pièces d'insertion (83, 85) font saillie dans cette chambre de réception (57) et
c) le dispositif de condensateur (1) avec le circuit de commande (3) posé dessus est poussé par l'autre partie de boîtier (4) contre les extrémités de contact (86, 84) des pièces d'insertion (83, 85).

12. Système d'allumage pyrotechnique selon la revendication 11, **caractérisé en ce que** les extrémités de contact (86, 84) des pièces d'insertion (83, 85) sont constituées avec une élasticité de ressort.

13. Système d'allumage pyrotechnique selon la revendication 11, **caractérisé en ce que** les extrémités de contact (86) des pièces d'insertion (83, 85) et les zones de contact (37) correspondantes sur le circuit de commande (3) sont connectées par un adhésif conducteur ou une brasure par refusion.

14. Système d'allumage pyrotechnique selon la revendication 11, **caractérisé en ce que**, entre les extrémités de contact (86) des pièces d'insertion (83, 85) et les zones de contact (37) correspondantes sur le circuit de commande (3), il est prévu une feuille flexible (36) qui présente des deux côtés un adhésif conducteur ou une brasure par refusion ainsi que des connexions électriques entre les côtés de la feuille.

15. Système d'allumage pyrotechnique selon la revendication 12, **caractérisé en ce que** le moyen d'allumage est disposé en tant que couche d'allumage (6) sur la feuille flexible sur le circuit de commande (3).

16. Système d'allumage pyrotechnique selon une des revendications précédentes 9 à 15, **caractérisé en ce que** le dispositif de condensateur est constitué comme un condensateur standard avec un boîtier (17) avec au moins une surface extérieure plane et des surfaces de contact électriques (16), le circuit de commande (3) étant connecté via les pièces d'insertion métalliques (85) aux surfaces de contact électriques (16).

17. Système d'allumage pyrotechnique selon la revendication 8, **caractérisé en ce que** au moins un groupe de pièces d'insertion (83) est conduit hors du boîtier et **en ce que**, à cet endroit, les connexions extérieures (81, 82) sont formées d'une seule pièce à partir des pièces d'insertion (83).

18. Système d'allumage pyrotechnique selon la revendication 18, **caractérisé en ce que** les connexions extérieures formées d'une seule pièce à partir des pièces d'insertion (83) sont formées en tant que contacts à borne à guillotine (41).

19. Système d'allumage pyrotechnique selon la revendication 18, **caractérisé en que** les connexions extérieures formées d'une seule pièce à partir des pièces d'insertion (83) sont formées en tant que broches de connexion (82).

20. Système d'allumage pyrotechnique selon la revendication 4, **caractérisé en ce que**, à partir de la structure de piste conductrice (2), des zones de contact (27) sont formées sur le dispositif de condensateur (1), auxquelles les zones de contact (34) affectées sont connectées sur le côté adjacent du circuit de commande (3).

21. Système d'allumage pyrotechnique selon la revendication 20, **caractérisé en ce que** le circuit de commande (3) est disposé via les zones de contact (34) sur le dispositif de condensateur (1) selon la technique de connexion par billes.

22. Système d'allumage pyrotechnique selon la revendication 4, **caractérisé en ce que**
a) le dispositif de condensateur (1) est exécuté en tant que dispositif de condensateur à plaques, avec plusieurs plaques d'isolement diélectriques (14) sur lesquelles des armatures de condensateur (15) au moins partiellement métalliques sont déposées.
b) des pistes conductrices (21) étant placées sur le/les côté(s) extérieur(s) (11, 12) de la / des plaque(s) extérieure(s) et
c) d'autres pistes conductrices (28) latérales étant disposées sur les surfaces latérales (13) perpendiculairement aux plaques de condensateur et les différentes armatures de condensateur (15) étant, via ces pistes conductrices latérales (28), câblées les unes avec les autres pour former au moins un condensateur, ainsi que câblées avec les autres composants électriques (3).

23. Système d'allumage pyrotechnique selon la revendication 4, **caractérisé en ce que**, à partir de la structure de piste conductrice (2), un éclateur (22) et/ou une résistance électrique est constitué(e) pour la décharge de charges électrostatiques.

24. Système d'allumage pyrotechnique selon la revendication 4, **caractérisé en ce qu'**un circuit électronique de déclenchement disposé à l'extérieur du boîtier est connecté au système d'allumage via une connexion électrique (43), des éléments de contacts (42) étant prévus à l'intérieur du boîtier (4), qui entrent directement en contact avec des zones de contact (26) formées à partir de la structure de piste conductrice (2).

25. Système d'allumage pyrotechnique selon la revendication 6, **caractérisé en ce que**, sur le côté supérieur du circuit de commande (3), le moyen d'allumage est exécuté avec deux secteurs de contact isolés l'un de l'autre qui sont connectés l'un à l'autre via une couche d'allumage (6) pyrotechnique.

26. Système d'allumage pyrotechnique selon la revendication 6, **caractérisé en ce que** le moyen d'allumage est constitué en tant qu'allumeur en pont à semiconducteurs, et les secteurs de contact (35) avec la couche d'allumage (6) sur le côté supérieur du circuit de commande (3) exécuté de façon non emballée sont réalisés par des secteurs dopés de façon conductrice isolés les uns des autres.

27. Système d'allumage pyrotechnique selon une des revendications 2 à 26, **caractérisé en ce que** le dispositif de condensateur (1), le circuit de commande (3) et le boîtier (4, 5) sont scellés de façon étanche à la pression, en particulier par assemblage soudé, brasé, pressé, serti ou collé.

28. Système d'allumage pyrotechnique selon une des revendications 2 à 27, **caractérisé en ce que** le boîtier (4, 5), entre la chambre de réception (57, 42) pour le dispositif de condensateur (1) avec le circuit de commande (3) et une chambre de charge propulsive (52) dans laquelle la charge propulsive (7) est disposée, présente une séparation (55) qui n'est interrompue que par une ouverture (56) au-dessus de l'allumeur (6), à travers laquelle l'allumeur (6) allume la charge propulsive (7).
